(19) Europäisches Patentamt
European Patent Office
Office européen des brevets

(11) **EP 4 603 909 A1**

(12) **EUROPEAN PATENT APPLICATION**

(43) Date of publication:
**20.08.2025 Bulletin 2025/34**

(21) Application number: **24157507.5**

(22) Date of filing: **14.02.2024**

(51) International Patent Classification (IPC):
*G03F 7/00* (2006.01)

(52) Cooperative Patent Classification (CPC):
**G03F 7/70633; G03F 7/706847; G03F 7/706851**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **ASML Netherlands B.V.
5500 AH Veldhoven (NL)**

(72) Inventors:
• **VAN PUTTEN, Eibert, Gerjan
5500 AH Veldhoven (NL)**

• **TINNEMANS, Patricius, Aloysius, Jacobus
5500 AH Veldhoven (NL)**
• **COENE, Willem, Marie, Julia, Marcel
5500 AH Veldhoven (NL)**

(74) Representative: **ASML Netherlands B.V.
Corporate Intellectual Property
P.O. Box 324
5500 AH Veldhoven (NL)**

Remarks:
A request for correction of the drawings has been filed pursuant to Rule 139 EPC. A decision on the request will be taken during the proceedings before the Examining Division (Guidelines for Examination in the EPO, A-V, 3.).

(54) **METROLOGY METHOD AND ASSOCIATED METROLOGY DEVICE**

(57)   Disclosed is a metrology method comprising: obtaining metrology data relating to a measurement obtained by illuminating a periodic structure comprising at least one pitch with partial coherent illumination comprising a wavelength and capturing the resultant scattered radiation from said periodic structure at a detection plane, said scattered radiation passing through at least one angularly resolved plane between said periodic structure and detection plane, said angularly resolved plane comprising at least one mask edge; non-iteratively reconstructing a field of said scattered radiation; using said reconstructed field to determine a parameter of interest of the structure; and in an initial step: selecting said wavelength and a maximum of said at least one pitch such that the wavelength-over-pitch ratio is greater than a first distance in said angularly resolved plane.

Fig. 10

EP 4 603 909 A1

**Description**

FIELD

The present invention relates to a metrology method and device which may, for example, be used for determining a characteristic of structures on a substrate.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as $CD = k_1 \times \lambda/NA$, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, it is desirable to make frequently measurements of the structures created, e.g., for process control and verification. Various tools for making such measurements are known, including scanning electron microscopes or various forms of metrology apparatuses, such as scatterometers. A general term to refer to such tools may be metrology apparatuses or inspection apparatuses.

In many metrology applications, it is desirable to access the full electric field (i.e., intensity and phase) rather than only intensity. Holography tools enable this, however they require a reference beam and very stringent operation to ensure interference between the reference beam and measurement radiation beam. Other phase retrieval methods may comprise an iterative retrieval of phase, however these are computationally demanding,

It would be desirable to improve on present methods for measuring the full electric field in metrology applications.

SUMMARY

Embodiments of the invention are disclosed in the claims and in the detailed description.

In a first aspect of the invention there is provided a metrology method comprising: obtaining metrology data relating to a measurement obtained by illuminating a periodic structure comprising at least one pitch with partial coherent illumination comprising a wavelength and capturing the resultant scattered radiation from said periodic structure at a detection plane, said scattered radiation passing through at least one angularly resolved plane between said periodic structure and detection plane, said angularly resolved plane comprising at least one mask edge; non-iteratively reconstructing a field of said scattered radiation; using said reconstructed field to determine a parameter of interest of the structure; and in an initial step: selecting said wavelength and a maximum of said at least one pitch such that the wavelength-over-pitch ratio is greater than a first distance in said angularly resolved plane, said first distance comprising the distance between said at least one mask edge and a furthest extent of at least one specular component of the scattered radiation with respect to said mask edge.

These and other aspects and advantages of the apparatus and methods disclosed herein will be appreciated from a consideration of the following description and drawings of exemplary embodiments.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 is a schematic illustration of a scatterometry apparatus;
- Figure 5 comprises (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements (d) a third pair of illumination apertures combining the first and second pair of apertures;
- Figure 6(a) is a schematic illustration of a known method of an arrangement for one-shot non-iterative phase retrieval where the specular beam is aligned with the mask; and Figure 6(b) is a schematic illustration illustrating a problem with extending such an arrangement to a partial coherent illumination case;
- Figure 7(a) schematically illustrates an optical field for partial coherent case where the specular radiation is misaligned with the mask edge; and Figure 7(b) schematically illustrates the reconstructed field comprising a first region where the reconstruction is bad and second region where the reconstruction is good;
- Figure 8 is a detection pupil plane representation illustrating parameters relevant for concepts disclosed herein;
- Figure 9 is a flowchart of a method according to concepts disclosed herein;
- Figure 10(a) is a detection pupil plane representation illustrating the physical locations of the specular and diffracted beams for a known method; and Figure 10(b) is a detection pupil plane representation illustrating the location of specular and diffracted beams for a method according to concepts disclosed herein
- Figure 11 is a pupil plane representation of the reconstructed fields illustrated in Figure 10(b); and
- Figure 12 depicts a block diagram of a computer system for controlling a metrology method and/or device such as disclosed herein.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

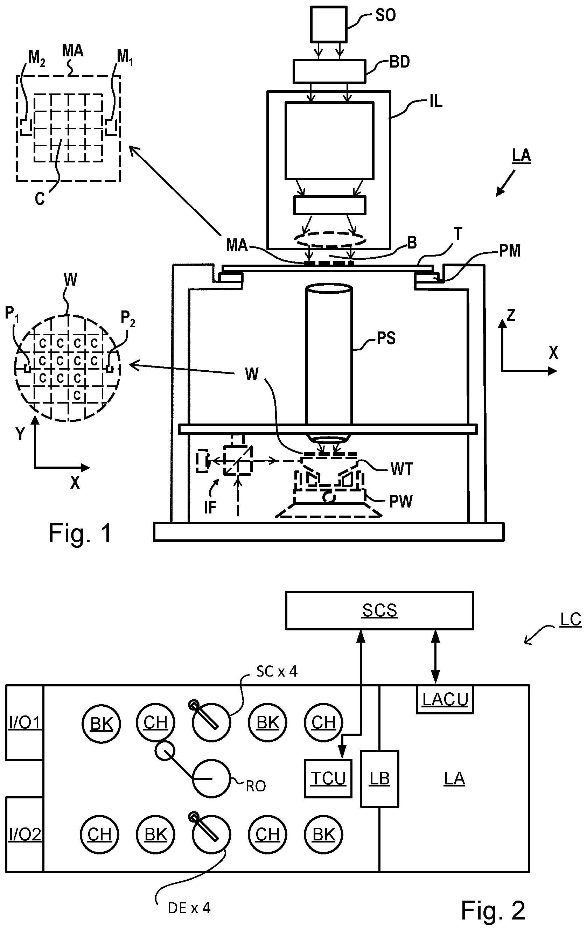

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

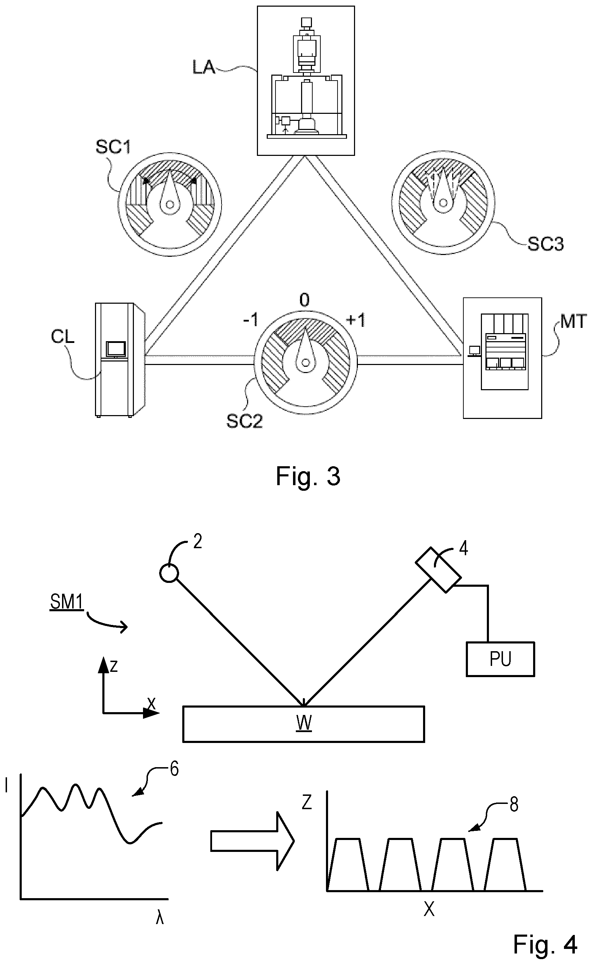

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MET (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 3 by the arrow pointing "0" in the second scale SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometer illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers ca measure in one image multiple targets from multiple gratings using light from soft x-ray and visible to near-IR wave range.

A metrology apparatus, such as a scatterometer, is depicted in Figure 4. It comprises a broadband (white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation 10. From this data, the structure or profile 8 giving rise to the detected spectrum may be reconstructed by processing unit PU, e.g. by Rigorous Coupled Wave Analysis and non-linear regression or by comparison with a library of simulated spectra. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety. Other parameters of interest may be focus and dose. Focus and dose may be determined simultaneously by scatterometry (or alternatively by scanning electron microscopy) as described in US patent application US2011-0249244, incorporated herein by reference in its entirety.

The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

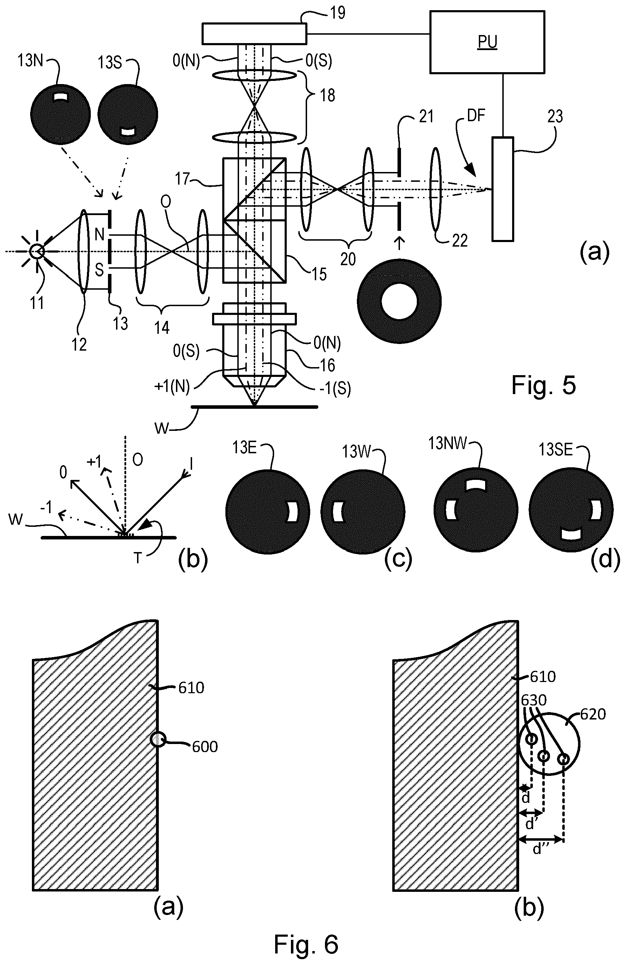

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 11 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane or angularly resolved plane. In particular, this can be done by inserting an aperture plate 13 of suitable form between lenses 12 and 11, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 5(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

As an alternative to a scatterometer, a metrology device may comprise a holographic microscope such as a digital holographic microscope (DHM) or digital dark-field holographic microscope. Such as device is disclosed, for example, in US2019/0107781 and WO2021121733A1 both of which is incorporated herein by reference.

In a scatterometry metrology tool, light may be used to create an image (e.g., at one or both of an image plane or pupil plane/angularly resolved plane) of a structure on a substrate. Such tools may measure the intensity or amplitude (or related measurement parameter such as diffraction efficiency) of the detected light, e.g., after having been scattered by the structure, and use this to determine one or more parameters of interest of the structure. In many cases, it may be beneficial to know the complex field (i.e., amplitude and phase) of the light scattered by the structure.

There are a number of present methods which enable the phase to be determined, in addition to the measured intensity/amplitude. One such technology is the aforementioned DHM, however holographic methods are typically subject to strict stability requirements and/or very low acquisition times, to suppress mechanical vibrations and/or drift and therefore achieve the necessary interference of the scattered radiation with reference radiation at the detector.

Another known method comprises performing multiple measurements under various conditions (e.g., different focus levels) and reconstructing the complex field of the scattered light using an iterative algorithm (e.g. as described in WO2021/121733, incorporated herein by reference). However, such methods are computationally very demanding/expensive and can be slow as a consequence, particularly as the accuracy of the retrieved phase is required to be higher in metrology than for more conventional phase retrieval applications such as microscopy and which require only the formation of an image. Other technologies are also known such as using masks having a pinhole or similar aperture in the detection branch of the tool, which allows an interferometric measurement (e.g. as described in WO2020/254041, incorporated herein by reference).

A non-iterative method for determining the complex field of the scattered radiation will now be described, based on causality, such as which applies in the (one-dimensional) time versus angular frequency context. This time causality stems from the fact that the electric field cannot travel faster than the speed of light, leading to an electric field $E=0$ for a time $t<0$ constraint. This time/causality constraint leads to a symmetry relationship of the electric field in the angular frequency domain. This symmetry relation is often referred to as the Kramers-Kronig relationship (and its inverse, which is the second Kramers-Kronig relationship). In an spatio-angular analogy of this concept, the time constraint may be replaced/implemented by locating a mask in the pupil plane (i.e., angularly resolved plane), such that the time coordinate $t$ becomes the pupil coordinate, and the angular frequency coordinate $\omega$ becomes the sensor/camera (image plane) coordinate. Because the Kramers-Kronig relationship comprises a linear integral transform (in essence a convolution operation), the (one-dimensional) Kramers-Kronig expression(s), expressed in terms of Fourier transforms, may be extended into a two-dimensional analysis; i.e., the two dimensions of the pupil plane/image plane.

Applying the Kramers-Kronig relationship to non-iteratively extract phase information, and therefore the full field, requires applying the phase extraction algorithm to an intensity image which is the result of an optical field having a single-sided spectrum. Typically, in a practical implementation when measuring using bright-field conditions, this may be achieved by filtering out one side of spectrum (e.g., with respect to the specular beam) using a physical mask within the pupil plane. For example, the pupil edge may be used as the mask, e.g., by centering the specular beam (or each diffracted/scattered beam of interest in a dark-field embodiment) on the pupil edge in the pupil plane such that the edge clips (i.e., blocks) half of the beam.

However, masking the beam is non-optimal as it limits applicability of Kramers-Kronig based methods using, for example, a setup such as that illustrated in Figure 5(a) to certain situations such as a limited $\lambda/p$ range (where $\lambda$ is the wavelength(s) of the measurement radiation used and p is the target pitch) and/or limited coherence conditions for the measurement radiation and/or requires the provision of a dedicated mask in the pupil plane (which is not desirable).

In particular, such Kramers-Kronig based methods are typically employed in combination with the use of coherent illumination, e.g., for performing microscopy. For microscopy to work, it is important to reconstruct the full complex field accurately. Due to this requirement, a strict alignment of the specular reflection with the mask is required, as any misalignment would introduce an error term on the reconstructed field (due to the requirement for a single-sided spectrum), thereby introducing unwanted artifacts in the resulting microscopy image.

However, it may be preferable to use illumination which is not coherent, e.g., partial coherent radiation. In particular, many present metrology apparatuses (e.g., such as that illustrated in Figure 5(a)) already use partial coherent illumination and it is desirable to use such apparatuses for non-iterative phase retrieval without significant hardware/source changes or spatial filtering of the light source, the latter option coming at the expense of light throughput. Also, using a coherent source makes the system sensitive to coherent imaging artifacts and reduces the robustness of any practical implementation due to the strict alignment requirements of the beam with respect to the mask.

Figure 6 illustrates the difference between (Figure 6(a)) using a coherent illumination beam 600 and (Figure 6(b)) using a partial coherent illumination beam 620. In Figure 6(a) the coherent illumination beam 600 is carefully aligned with the mask 610, e.g., such that half of the beam is blocked by the mask edge. Because partial coherent illumination can be seen as a collection of mutually incoherent point sources 630 (three such sources shown, arbitrarily chosen) spatially distributed across a finite area, it is impossible to align all of these point sources with the mask 610. Each (or at least many) of these point sources will be at a different distance d, d', d" from the mask 610. These misalignments thereby inevitably add an error in a subsection of the reconstructed pupil; it is not possible to obtain the single-sided spectrum condition for all of the pupil area covered by partial coherent illumination. It is for this reason that coherent illumination is always used for Kramers-Kronig based non-iterative microscopy in the state of the art.

It is proposed herein to combine the non-iterative phase retrieval algorithms (e.g., Kramers-Kronig based non-iterative phase-retrieval algorithms) with partial coherent illumination.

In particular, it is proposed to use partial coherent illumination in combination with diffraction based metrology such as diffraction based overlay (DBO) or diffraction based focus (DBF) metrology. Diffraction based metrology such as DBO/DBF comprises comparing complementary diffraction orders (i.e., diffraction orders of the same order number either side of the specular beam such as the +1 and - 1 diffraction orders; i.e., diffraction orders having the same magnitude diffraction angle with respect to the specular beam) to determine an asymmetry in the scattering structure or target, from which a parameter of interest (e.g., overlay or focus) can be extracted. The proposed method comprises properly selecting wavelength and target pitch (e.g., $\lambda/p$ ratio) to enable suitable reconstruction of the electric field.

The concepts herein take advantage of the fact that diffraction based metrology techniques such as DBO/DBF do not require a faithful reconstruction of the full pupil, which is in contrast to microscopy. Misalignment of (part of) the illumination beam with respect to the mask, which is the case when a partial coherent illumination spot of finite size is used, is acceptable provided that the reconstruction error term that is introduced does not overlap in the pupil plane with the desired diffraction orders (i.e., does not overlap with the pupil region where the desired diffraction orders, e.g., +1/-1 orders, are located and where a region of interest may be defined).

Consider a diffraction based metrology setup, such as illustrated in Figure 5(a), illuminating and measuring the reflected light coming from a target. The setup uses partial coherent illumination and the spatial pattern of the light propagating through the illumination and detection pupil planes can be controlled with apertures. The target creates several diffraction orders, at least some of which may be used for parameter of interest inference (diffraction orders of interest).

The method may comprise defining a region of interest in a region at least partially comprising at least portions of each of the relevant diffraction orders in the detection pupil plane. The region of interest may be a non-contiguous region (e.g., multiple sub-regions) defining a subset of the full available detection NA, such that the size of each of these sub-regions in the relevant dimension $NA_{ROI}$. In this context, "the relevant direction" means that the size of the sub-region in the $k_x$ direction for a sub-region of interest comprising (at least a portion of) a diffraction order from an X-grating or X-oriented sub-target and size of the sub-region in the $k_y$ direction for a sub-region of interest comprising (at least a portion of) a diffraction order from a Y-grating or Y-oriented sub-target, where $k_x$, $k_y$ is the pupil plane coordinate system corresponding to the substrate plane coordinate system X, Y). The region of interest will have a minimum distance $\mathrm{NA}_{\mathrm{ROI}}^{\min}$ and a maximum distance $\mathrm{NA}_{\mathrm{ROI}}^{\max}$ from the specular reflection. The reconstructed electric field corresponding to the region of interest can be filtered out from the full reconstructed field and used for further processing, e.g., digital correction and/or parameter of interest inference.

The methods described herein rely on the insight that there is a region within the pupil plane NA area for which the field can be reconstructed even when there is misalignment of (part of) the specular beam with respect to the mask, which will always be the case for finite area partial coherent radiation. Provided that the diffracted radiation (i.e., the wanted diffracted orders) are within this region then the relevant phase can be retrieved.

The phase retrieval algorithms described herein act on the measured intensity image in the field plane. Any potential global linear phase gradient present in the original field is lost at the detector in measuring intensity. The result of this is that the spatial frequencies in the reconstructed field, $\Delta k_x$ and $\Delta k_y$, are not absolute but are all relative to the specular reflections and therefore potentially shifted with respect to the real optical field. This offset is in practice easily handled and corrected for as in general the diffraction orders of interest are those at a well-known relative spatial frequency of $k_{\mathrm{diffr}} = \pm 1/p$ with respect to the specular reflection. Misalignment of the specular beam with respect to the mask introduces (in general) a different type of error in the reconstructed field: it results in an error in the reconstructed part of the field which is localized in the pupil at the lower relative spatial frequencies $|\Delta k_x| < \delta \mathrm{NA}_{\mathrm{edge}}/\lambda$. Provided that the region of interest is at a relative spatial frequency that is higher than the extent of this error, this part of the optical field can still be correctly reconstructed.

In the reconstructed field there is an ambiguity of the global linear phase in the field plane. The reason for this is that there may be two fields that differ only by a global linear phase gradient and would result in the same intensity image. As a result, the reconstruction effectively places the specular reflection on the center (origin) of the reconstructed pupil, with the diffraction orders at A/p away from the origin. As such, the reconstruction may be considered to be a reconstruction of $\Delta k_x$, $\Delta k_y$ rather than $k_x$, $k_y$; i.e., the pupil positions relative to the specular reflection. This has the advantage that for partial coherent illumination, all different mutually incoherent regions in the illumination spot are mapped onto each other in the origin of the reconstruction and the resulting diffraction orders of each of the mutually incoherent regions all land at A/p. Therefore, if a camera were to be placed in the pupil plane, it would see that for a large illumination the diffraction orders get 'smeared out' over the pupil; in the reconstruction this smearing is not present as all diffraction orders (of interest) are centered at $\Delta k_x = \lambda/p$. This additionally enables easier pupil filtering as the region of interest can be chosen relatively tightly around $\lambda/p$ without having to take the finite illumination spot size into account.

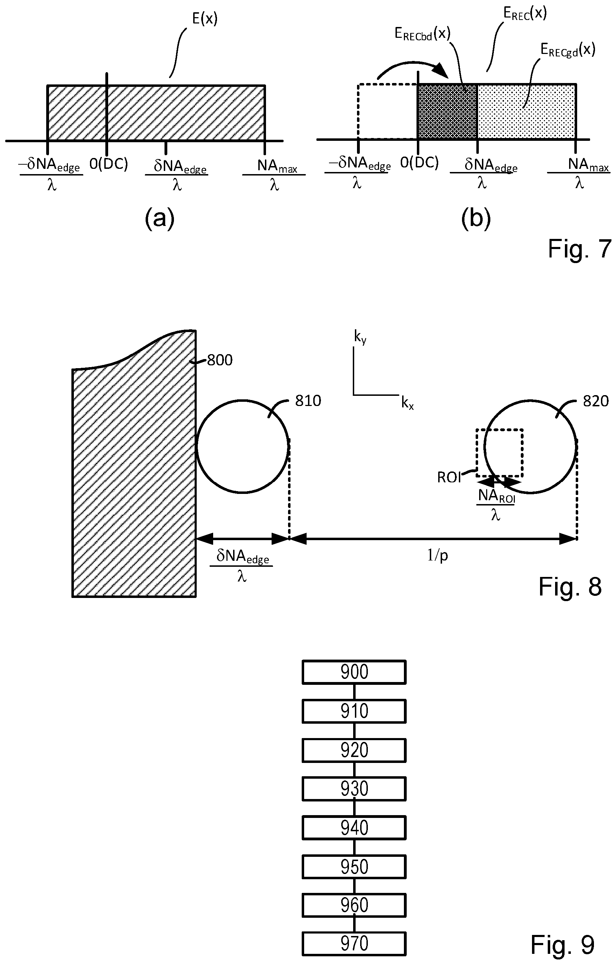

Figures 7 and 8 illustrate this concept. Figure 7(a) shows a schematic spectrum of an optical field $E(x)$ and Figure 7(b) shows the reconstructed field $E_{REC}(x)$, each being shown as field strength against relative spatial frequency (wave vector) $\Delta k_x$. In this example, the specular reflection at $\Delta k_x = 0$ (DC) is misaligned with the edge of the mask by $\Delta k_x = -\delta \mathrm{NA}_{\mathrm{edge}}/\lambda$ corresponding to the part of the partial coherent illumination that has the largest distance from the mask edge. The parameter $\delta \mathrm{NA}_{\mathrm{edge}}/\lambda$ is illustrated in Figure 8, which represents the detection pupil plane comprising a mask 800, a zeroth order (specular) illumination beam 810 and a first order illumination beam 820 at a distance 1/p from the specular beam 810.

Returning to Figure 7(b), the portion $E_{RECbd}(x)$ of the reconstructed field $E_{REC}(x)$ at low spatial frequencies $0 \leq \Delta k_x \leq \delta \mathrm{NA}_{\mathrm{edge}}/\lambda$ comprises an overlap with the negative spatial frequencies in the original field (i.e., the signal that was in the original field at negative frequencies is now overlapping in the reconstructed field with the positive frequencies), thereby incorrectly reconstructing that part of the spectrum. At higher spatial frequencies $\Delta k_x > \delta \mathrm{NA}_{\mathrm{edge}}/\lambda$, the spectrum $E_{RECgd}(x)$ is correctly reconstructed. By properly choosing the wavelength $\lambda$ and the pitch p, it is possible to ensure that the region of interest ROI around the diffraction orders 810 defining a subset of the numerical aperture $\mathrm{NA}_{\mathrm{ROI}}$, fall completely within the portion of the reconstructed spectrum $E_{RECgd}(x)$ where the field is properly reconstructed. Note that the region of interest may comprise non-contiguous sub-regions, each respectively corresponding to a different diffraction order of interest, the size(s) of the sub-region defining $\mathrm{NA}_{\mathrm{ROI}}$.

Figure 9 is a flowchart describing a method to obtain (a proper representation of) the complex optical field (i.e., phase and amplitude) in the pupil at the location of this region of interest; something that normally cannot be directly measured.

At step 900, the target may be illuminated with one or more regions of partial coherent illumination, each region spanning a finite NA area of the illumination pupil (illumination pupil plane).

At step 910, a mask may be applied (or more typically is already present) in detection pupil plane, having a position such that the maximum distance between the mask and any part of the specular reflection regions is $\delta \mathrm{NA}_{\mathrm{edge}}/\lambda$. This mask may be defined by the extent of the detection NA (i.e., a detection pupil stop and/or an edge (extent) of an optical directing element such as a quadrant edge of an optical four-fold wedge element).

At step 920, a region of interest containing a subset of relative spatial frequencies, $\Delta k \in NA_{ROI}/\lambda$, may be defined between a minimum ROI extent $|\Delta k_{min}|$ and a maximum ROI parameter $|\Delta k_{max}|$ relative to the specular reflection, such that $|\Delta k_{min}| > \delta NA_{edge}/\lambda$. The ROI parameter $|\Delta k_{max}|$ may have a maximum naturally determined by the maximum detection NA $NA_{max}$ of the system relative to the specular reflection, i.e., $|\Delta k_{max}| \leq NA_{max}/\lambda$. The first distance $\delta NA_{edge}/\lambda$ comprises the distance between said at least one mask edge and a furthest extent of at least one specular component (e.g., the specular beam) of the scattered radiation with respect to said mask edge. For example, the relevant mask edge for this definition may comprise the nearest mask edge to the (e.g., respective) specular component, e.g., in the relevant measurement direction (e.g., in the $k_x$ direction when measuring X oriented targets and/or in the $k_y$ direction when measuring Y oriented targets).

The $\dfrac{\lambda}{p}$ ratio should be sufficiently greater than the minimum ROI parameter $|\Delta k_{min}|$ and therefore greater than the first distance $\delta NA_{edge}$ to enable reconstruction within at least the region of interest, which leads to the criterion $\dfrac{1}{p} > \delta NA_{edge}/\lambda$ (i.e., $\dfrac{\lambda}{p} > \delta NA_{edge}$). When the target comprises multiple pitches (e.g., varies with the target length), $p$ is the largest pitch. When the illumination is comprises multiple wavelengths, $\lambda$ is the shortest wavelength. Of course, there may be a maximum $\dfrac{\lambda}{p}$ ratio defined by and maximum ROI parameter $|\Delta k_{max}|$ and therefore the effective numerical aperture of the detection branch $NA_{max}$: i.e., $\dfrac{1}{p} < NA_{max}/\lambda$.

It can be advantageous to be able to select the ROI in the spatial domain, which requires the whole diffraction order to be captured. To facilitate this, in an embodiment, the lower limit for the $\dfrac{\lambda}{p}$ ratio may be greater than the first distance by at least a second distance $NA_{ROI}/2\lambda$; i.e., $\dfrac{1}{p} > \delta NA_{edge}/\lambda + NA_{ROI}/2\lambda$.

At step 930, metrology data comprising the intensity $I(x) = \Sigma|E(x)|^2$ is measured in the field plane (e.g., at a detector in a detector plane or field plane), where in the summation is included as the sum over the power of the fields originating from each of the mutually incoherent areas within the illumination spot.

At step 940, a non-iterative phase retrieval is performed on the measured data to reconstruct an optical field $E_{REC}(k_x)$ corresponding to the pupil plane.

At step 950, the region of interest is cropped from the reconstructed field to create local reconstructed field $E_{REC}^{ROI}(k_x)$ (e.g., comprising one or more, optionally non-contiguous, local reconstructed sub-fields). The local reconstructed field $E_{REC}^{ROI}(k_x)$ can then be manipulated as desired. By way of specific examples, at step 960 digital processing (e.g., digital correction and/or filtering) may be performed on the local reconstructed field. Such digital processing may correct for optical aberration within the metrology optics. Alternatively or in addition, such digital processing may correct for and/or reduce the impact of optical crosstalk from neighboring structures on the inferred parameter of interest.

At step 970, the parameter of interest may be determined from the digitally processed local reconstructed field. This step may comprise (digitally) reimaging the local reconstructed field $E_{REC}^{ROI}(k_x)$ (e.g., comprising sub-fields corresponding to each diffraction order of interest, such as a pair of complementary diffraction orders, e.g., +1/-1 diffraction orders (optionally a pair of complementary diffraction orders per X and Y direction of the substrate plane)). The parameter of interest may then be determined (e.g., optionally per direction) from a comparison or difference of the diffraction order of each pair (e.g., comparing the +1 order and -1 order).

In an embodiment, the region of interest may comprise multiple non-contiguous sub-regions of equal area, or at least the sub-regions corresponding to each diffraction order of each complementary pair of diffraction orders (i.e., sub-regions per measurement direction), may be of equal area. This may be beneficial as the parameter of interest may be inferred from a comparison of the diffraction orders of each complementary pair of diffraction orders. As an alternative, a single contiguous ROI may be defined which covers at least a portion of the diffraction orders of interest. In an embodiment, each sub region or the single contiguous region may comprise the same amount, or same area of each diffraction order of interest or of each diffraction order of interest per measurement direction (purely for example, each sub region may comprise a third, or a half of each diffraction order). In an embodiment, a contiguous region or each sub region may comprise corresponding portions of each diffraction order (further optionally only per measurement direction).

In an embodiment, a different ROI may be defined for e.g. steps 950 and 960 above, with an additional filtering step included (e.g., as part of step 960) to reduce the ROI size. Such a method may maximize the ROI in step 950, and apply additional digital filtering in step 960 to potentially reduce the ROI (e.g., reduce one or more of the sub-regions or reduce the amount of diffraction order covered for one or more of the diffraction orders of interest).

Alternatively or in addition, different sized sub-regions may be defined for the different measurement directions X, Y, or a single contiguous ROI may cover different sized regions of the X-diffraction orders of interest and the Y-diffraction orders of interest. For example, if there is a neighboring structure close to the target with a certain pitch in the Y-direction; then the ROI may be defined to cover a smaller portion of the Y-diffraction orders to remove or mitigate potential crosstalk from that neighboring structure.

It can be appreciated that a reconstructed complex field relating to partial coherent illumination represents an average (e.g., a weighted average with unknown weights) of individual fields from the (effective) individual point sources within the partial coherent illumination. Aberration correction can still be performed, subject to a few changes with respect to a coherent illumination case.

For example, for a uniform 1st order diffraction response of the target, the dual-beam phase transfer function may be averaged over the angular range of the source size within the illumination NA. Where there is any such angular dependence of the 1st order response, the situation is more difficult, and requires some prior knowledge of the angular dependencies. Such corrections be impractical from a metrology point of view.

Examples of suitable algorithms for the phase retrieval at step 940 may be found in (or adapted from), for example, a number of publications such as, for example: Nakajima, N., and T. Asakura. Two-dimensional phase retrieval using the logarithmic Hilbert transform and the estimation technique of zero information. Journal of Physics D: Applied Physics 19, no. 3 (1986): 319; Baek, Y., Lee, K., Shin, S., Park, Y., 2019; Kramers-Kronig holographic imaging for high-space-bandwidth product. Optica, OPTICA 6, 45-51; Baek, Y., Park, Y., 2021. Intensity-based holographic imaging via space-domain Kramers-Kronig relations, Nat. Photonics 15, 354-360; Shen, C., Liang, M., Pan, A., Yang, C., 2021. Non-iterative complex wave-field reconstruction based on Kramers-Kronig relations. Photon. Res., PRJ 9, 1003-1012. These documents are incorporated herein by reference. These are only examples and there are a large number of publications which describe suitable phase retrieval methods, as will be appreciated by the skilled person.

By way of a specific example, the (averaged) electric phase may be reconstructed from its modulus $|E(x)|$ as:

$$\int \arg\left(e^{-iax}E_{REC}(x)\right)d\lambda = \mathcal{F}\left(\text{sgn}(k_x)\mathcal{F}^{-1}\left(\int \ln|E(x)|\,d\lambda\right)\right)$$

where a is the mask edge position in the pupil plane:

$$1 + \text{sgn}(k_x) = \begin{cases} 0, & \text{for } k_x < 0 \\ 1, & \text{for } k_x = 0 \\ 2, & \text{for } k_x > 0 \end{cases}$$

This is of course a single dimension (x) example, and the concepts are equally applicable to the other dimension and simply adapted (as the skilled person will recognize) to the two-dimension case ($E_{REC}(x, y)$) or three-dimension case ($E_{REC}(x, y, \lambda)$).

It can be appreciated that the retrieved phase for each diffraction order is not an absolute phase, but is relative to the phase of the specular illumination.

A method will now be described specifically in the context of a metrology apparatus such as illustrated in Figure 5(a). Optionally, such an embodiment may further make use of one or both of a four-fold wedge element and an illumination mode selector, although these are not shown in Figure 5(a).

An illumination mode selector module is a form of spatial light modulation device or spatial light configuration device which enables control/configuration of the spatial pattern of the illumination pupil (i.e., the illumination configuration). However, other methods of configuring the illumination may be employed in such an apparatus, such as a more conventional spatial filter (e.g., as mounted to a filter wheel) with appropriate filtering configuration.

In the detection pupil plane, a four-fold wedge element may be used to split the field into four and direct radiation incident on each quadrant to a different part of the detector. Such a four-fold wedge element is well known for enabling simultaneous acquisition of +1 and -1 diffraction orders for both X and Y directions from illumination in two opposite directions, in combination with illumination from two diagonally opposed quadrants, in present dark-field µDBO/DBF (micro-DBO/DBF) metrology.

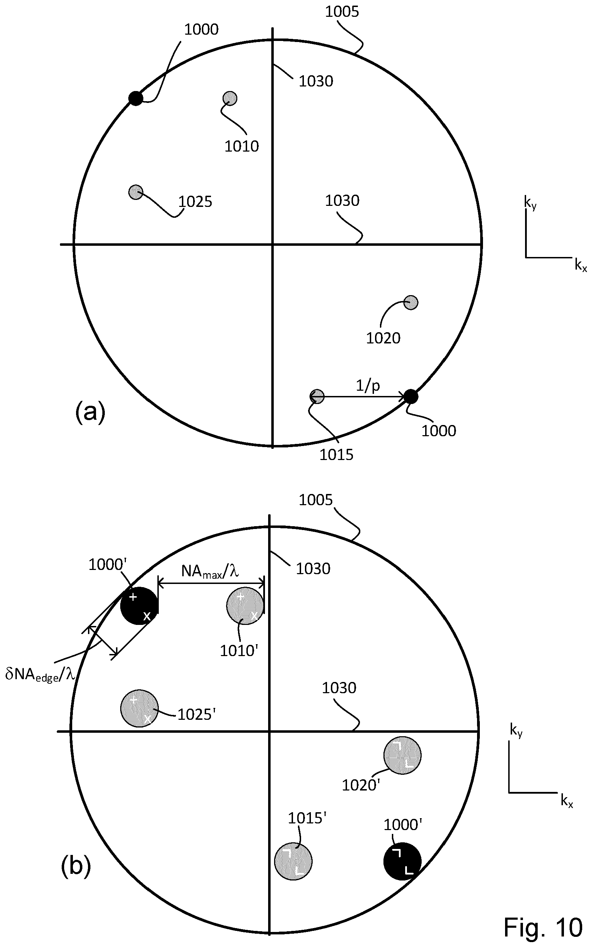

Figure 10(a) shows a typical pupil arrangement for employing non-iterative phase retrieval (Kramers-Kronig phase retrieval) using such a metrology apparatus. In such an arrangement, the illumination is such that the specular beams 1000 are aligned with the mask edge 1005 (i.e., the extent of the detection NA e.g., as defined by a detection pupil stop) such that half of each specular beam 1000 is blocked. One each of the +1X diffraction order 1010, -1X diffraction order 1015, +1Y diffraction order 1020 and -1Y diffraction order 1025 is captured within the detection NA 1005. Such an arrangement requires coherent illumination.

Figure 10(b) shows a possible detection pupil arrangement according to concepts disclosed herein. The illumination may be configured such that the specular beams 1000' are close to the pupil edge 1005, but fall (e.g., entirely) inside the detection NA. Each illumination beam comprises multiple mutually incoherent regions, as indicated by the different shapes inside the specular beam 1000' (two shapes per beam are shown being indicative of two arbitrary points per beam). The furthest extent of each specular beam 1000' from the pupil edge 1005 (note that an edge in this context may comprise the pupil edge and therefore may be curved) is at a distance $\delta NA_{edge}/\lambda$. For example, using an IMS or otherwise, an illumination configuration or aperture may be selected comprising openings correspondingly close to the edge of the illumination pupil as the specular beams are to the edge of detection pupil 1005. A wedge optic, with edges 1030, may be used to image each quadrant into a separate image on the camera. The distance between the illumination spot and the edges of the wedge optic defines an effective maximum $NA_{max}/\lambda$. Also shown are the diffraction orders of interest 1010', 1015', 1020', 1025', each shown with the corresponding (arbitrary) points indicated as its respective specular beam 1000'.

For both the intensity images resulting from the top left quadrant and the bottom right quadrant as illustrated in Figure 10(b), a respective field is reconstructed using the phase-retrieval algorithms described herein.

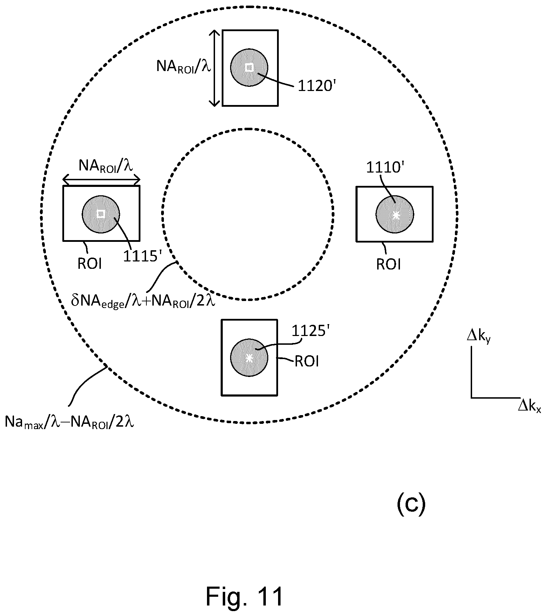

Figure 11 shows a representation of the reconstructed pupil for the combined two fields represented in Figure 10(b). A sub-region of interest ROI having a dimension (second distance) $NA_{ROI}$ in the relevant measurement direction may be defined around each reconstructed diffraction order 1110' , 1115' 1120' 1125' (corresponding respectively to diffraction orders 1010', 1015', 1020', 1025' in Figure 10(b)). Note that the averaging over the point sources of the partial coherent radiation is represented by a combining or merging of the shapes shown in Figure 10(b) at the center of each respective beam.

According to the concepts already described a lower limit of the wavelength-over-pitch ratio $\lambda/p$ may be defined as:

$$\frac{\lambda}{p} > \delta NA_{edge}$$

or advantageously:

$$\frac{\lambda}{p} > \delta NA_{edge} + NA_{ROI}/2$$

In addition, an upper limit of the wavelength-over-pitch ratio $\lambda/p$ may be defined to ensure that the desired diffraction orders 1010', 1015', 1020', 1025', including an associated sub-region of interest ROI fall inside the same quadrant within the detection pupil as the specular reflections 1000:

$$\frac{\lambda}{p} < NA_{max}$$

or advantageously:

$$\frac{\lambda}{p} < NA_{max} - NA_{ROI}/2$$

where $NA_{max}$ is the effective numerical aperture of the detection branch (taken into account any masking elements such as the wedge optic) and $NA_{ROI}$ is the extent of the respective sub-region of interest in the relevant measurement direction (e.g., $k_x$ for an X diffraction order and $k_y$ for a Y diffraction order). As shown here, each ROI sub-region may be chosen to be centered on its respective diffraction order such that $|\Delta k_{min}| = -NA_{ROI}/2\lambda$ and $\Delta k_{max}| = +NA_{ROI}/2\lambda$.

Summarizing the above, the wavelength-over-pitch ratio $\lambda/p$ range may be defined as:

$$\delta NA_{edge} + NA_{ROI}/2 < \frac{\lambda}{p} < NA_{max} - NA_{ROI}/2$$

This range is represented as the area between the dotted circles on Figure 11.

It should be noted that the boundaries separating the quadrants of the four-fold wedge element may comprise a finite extent (or 'dead-zone') due to manufacturing and optical safety margins, which would result in some of the diffraction order radiation being blocked. In order to be able to properly reconstruct the diffraction orders, the illumination spots may be extended to be significantly wider than this 'dead-zone', such that the diffraction orders extend sufficiently outside of it. This also means that the parameter $\delta NA_{edge}$ may differ from that illustrated in Figure 10(b), in that it may be reduced by half the width of the dead-zone (the dead-zone will be centered on each edge 1030), i.e., it will be the difference of the furthest extent of the partial coherent specular beam with respect to the beginning of this dead-zone (the beginning of the dead-zone being the effective mask edge).

It can be appreciated that the (non-contiguous) region of interest ROI illustrated in Figure 10(b) is largely arbitrarily defined, other than including at least a portion of each diffraction order of interest 1010', 1015', 1020', 1025' and being comprised within the aforementioned $\lambda/p$ limits.

An additional benefit of this arrangement is that two dark field images, respectively one from each of the two quadrants in which no specular reflection is present, is obtained from the same measurement. These are the regular dark field images that are currently used for parameter of interest inference in e.g., μDBO or μDBF. As such, these additional dark-field measurements may be used to complement the bright-field measurements which are the main subject of this specification, thereby increasing measurement robustness.

In addition, while the concepts herein have been described in relation to bright-field metrology, the concepts described can be applied equally to dark-field metrology, where the specular radiation is blocked.

Using the concepts disclosed herein it is possible to perform non-iterative phase retrieval using partial coherent illumination. This opens the applicability of such methods to a broader range of light sources, such as the ones currently used in many metrology devices. An additional benefit is that it provides for a more relaxed alignment condition of the specular reflection with respect to the mask, allowing for a more robust practical implementation of the technique. In this manner, a method of full-field metrology (e.g., with phase retrieved) may be achieved in a single acquisition (i.e. single shot). An additional benefit is that no programmable mask is required, which simplifies the implementation of the method.

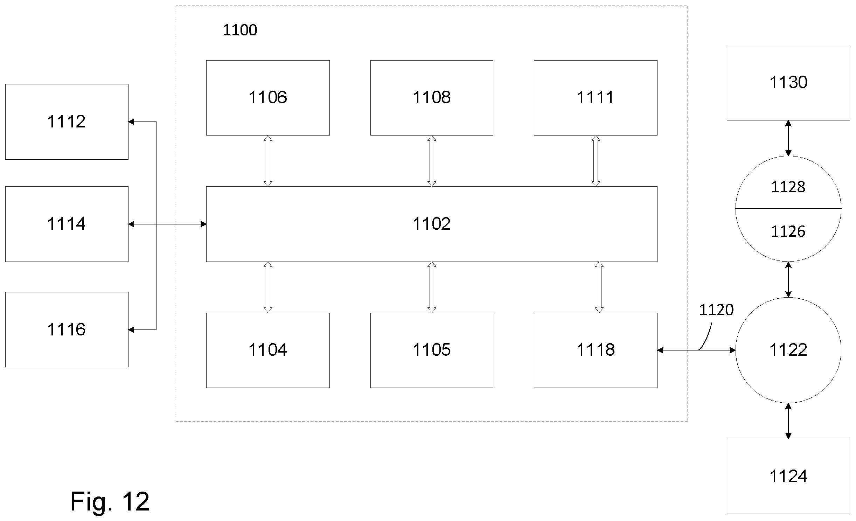

Figure 12 is a block diagram that illustrates a computer system 1100 that may assist in implementing the methods and flows disclosed herein. Computer system 1100 includes a bus 1102 or other communication mechanism for communicating information, and a processor 1104 (or multiple processors 1104 and 1105) coupled with bus 1102 for processing information. Computer system 1100 also includes a main memory 1106, such as a random access memory (RAM) or other dynamic storage device, coupled to bus 1102 for storing information and instructions to be executed by processor 1104. Main memory 1106 also may be used for storing temporary variables or other intermediate information during execution of instructions to be executed by processor 1104. Computer system 1100 further includes a read only memory (ROM) 1108 or other static storage device coupled to bus 1102 for storing static information and instructions for processor 1104. A storage device 1110, such as a magnetic disk or optical disk, is provided and coupled to bus 1102 for storing information and instructions.

Computer system 1100 may be coupled via bus 1102 to a display 1112, such as a cathode ray tube (CRT) or flat panel or touch panel display for displaying information to a computer user. An input device 1114, including alphanumeric and other keys, is coupled to bus 1102 for communicating information and command selections to processor 1104. Another type of user input device is cursor control 1116, such as a mouse, a trackball, or cursor direction keys for communicating direction information and command selections to processor 1104 and for controlling cursor movement on display 1112. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 1100 in response to processor 1104 executing one or more sequences of one or more instructions contained in main memory 1106. Such instructions may be read into main memory 1106 from another computer-readable medium, such as storage device 1110. Execution of the sequences of instructions contained in main memory 1106 causes processor 1104 to perform the process steps described herein. One or more processors in a multi-processing arrangement may also be employed to execute the sequences of instructions contained in main memory 1106. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 1104 for execution. Such a medium may take many forms, including but not limited to, non-volatile media, volatile media, and transmission media. Non-volatile media include, for example, optical or magnetic disks, such as storage device 1110. Volatile media include dynamic memory, such as main memory 1106. Transmission media include coaxial cables, copper wire and fiber optics, including the wires that comprise bus 1102. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 1104 for execution. For example, the instructions may initially be borne on a magnetic disk of a remote computer. The remote computer can load the instructions into its dynamic memory and send the instructions over a telephone line using a modem. A modem local to computer system 1100 can receive the data on the telephone line and use an infrared transmitter to convert the data to an infrared signal. An infrared detector coupled to bus 1102 can receive the data carried in the infrared signal and place the data on bus 1102. Bus 1102 carries the data to main memory 1106, from which processor 1104 retrieves and executes the instructions. The instructions received by main memory 1106 may optionally be stored on storage device 1110 either before or after execution by processor 1104.

Computer system 1100 also preferably includes a communication interface 1118 coupled to bus 1102. Communication interface 1118 provides a two-way data communication coupling to a network link 1120 that is connected to a local network 1122. For example, communication interface 1118 may be an integrated services digital network (ISDN) card or a modem to provide a data communication connection to a corresponding type of telephone line. As another example, communication interface 1118 may be a local area network (LAN) card to provide a data communication connection to a compatible LAN. Wireless links may also be implemented. In any such implementation, communication interface 1118 sends and receives electrical, electromagnetic or optical signals that carry digital data streams representing various types of information.

Network link 1120 typically provides data communication through one or more networks to other data devices. For example, network link 1120 may provide a connection through local network 1122 to a host computer 1124 or to data equipment operated by an Internet Service Provider (ISP) 1126. ISP 1126 in turn provides data communication services through the worldwide packet data communication network, now commonly referred to as the "Internet" 1128. Local network 1122 and Internet 1128 both use electrical, electromagnetic or optical signals that carry digital data streams. The signals through the various networks and the signals on network link 1120 and through communication interface 1118, which carry the digital data to and from computer system 1100, are exemplary forms of carrier waves transporting the information.

Computer system 1100 may send messages and receive data, including program code, through the network(s), network link 1120, and communication interface 1118. In the Internet example, a server 1130 might transmit a requested code for an application program through Internet 1128, ISP 1126, local network 1122 and communication interface 1118. One such downloaded application may provide for one or more of the techniques described herein, for example. The received code may be executed by processor 1104 as it is received, and/or stored in storage device 1110, or other non-volatile storage for later execution. In this manner, computer system 1100 may obtain application code in the form of a carrier wave.

Additional embodiments are disclosed in the subsequent list of numbered clauses:

1. A metrology method comprising:

obtaining metrology data relating to a measurement obtained by illuminating a periodic structure comprising at least one pitch with partial coherent illumination comprising a wavelength and
capturing the resultant scattered radiation from said periodic structure at a detection plane, said scattered radiation passing through at least one angularly resolved plane between said periodic structure and detection plane, said angularly resolved plane comprising at least one mask edge;
non-iteratively reconstructing a field of said scattered radiation;
using said reconstructed field to determine a parameter of interest of the structure; and in an initial step:
selecting said wavelength and a maximum of said at least one pitch such that the wavelength-over-pitch ratio is greater than a first distance in said angularly resolved plane, said first distance comprising the distance between said at least one mask edge and a furthest extent of at least one specular component of the scattered radiation with respect to said mask edge.

2. A metrology method as defined in clause 1, wherein the reconstructed field represents an average of individual fields from individual point sources within the partial coherent illumination.

3. A metrology method as defined in clause 1 or 2, wherein said selecting said wavelength and pitch further comprises: selecting an illumination configuration and therefore said first distance in addition to said wavelength and pitch such that the wavelength-over-pitch ratio is greater than the first distance in said angularly resolved plane.

4. A metrology method as defined in any preceding clause, comprising defining a region of interest within said angularly resolved plane, said region of interest comprising at least a portion of each diffraction order of a plurality of diffraction orders of interest comprised within said captured scattered radiation, said plurality of diffraction orders of interest comprising at least one complementary pair of diffraction orders.

5. A metrology method as defined in clause 4, comprising:

reimaging a local reconstructed field, the local reconstructed field comprising said reconstructed field cropped to correspond only to the region of interest; and
determining said parameter of interest from the reimaged local reconstructed field.

6. A metrology method as defined in clause 5, wherein said reimaging step comprises digitally reimaging the local reconstructed field.

7. A metrology method as defined in clause 5 or 6, comprising performing digital processing on the local reconstructed field.

8. A metrology method as defined in clause 7, wherein said digital processing comprises digital correction and/or filtering to correct for, reduce and/or remove optical aberration and/or correct for, reduce and/or remove the impact of optical crosstalk.

9. A metrology method as defined in any of clauses 5 to 8, comprising determining said parameter of interest from a comparison of reimaged diffraction orders of each of the at least one complementary pair of diffraction orders, as reimaged from said local reconstructed field.

10. A metrology method as defined in clause 9, wherein said region of interest comprises a corresponding proportion of each of the diffraction orders of each of the at least one complementary pair of diffraction orders.

11. A metrology method as defined in any of clauses 4 to 10, wherein said region of interest comprises a plurality of sub-regions of interest, each comprising at least a portion of a respective one of said plurality of diffraction orders of interest.

12. A metrology method as defined in clause 11, wherein said selecting step comprises selecting said wavelength and pitch such that the wavelength-over-pitch ratio is greater than the sum of the first distance and a second distance in said angularly resolved plane, said second distance comprising half of a dimension of said sub-regions of interest in the dimension corresponding to its respective diffraction order of interest.

13. A metrology method as defined in clause 12, wherein said selecting step comprises selecting said wavelength and pitch such that the wavelength-over-pitch ratio is smaller than the difference of the available maximum numerical aperture and said second distance.

14. A metrology method as defined in any of clauses 11 to 13, wherein each of said sub-regions of interest are equally dimensioned.

15. A metrology method as defined in any of clauses 4 to 14, comprising, in said step of non-iteratively reconstructing a field, using a Kramers-Kronig based algorithm to retrieve a phase of at least the diffraction orders of interest.

16. A metrology method as defined in clause 15, wherein said phase of at least the diffraction orders of interest is retrieved with respect to a phase of the specular component.

17. A metrology method as defined in any preceding clause, wherein said at least one mask edge comprises at least one edge of a detection pupil stop and/or extent of a detection numerical aperture.

18. A metrology method as defined in any preceding clause, wherein said illumination comprises two beams, illumination said structure from two directions

19. A metrology method as defined in any preceding clause, wherein said parameter of interest is overlay or focus.

20. A metrology method as defined in any preceding clause, wherein said metrology data comprises intensity data.

21. A metrology method as defined in any preceding clause, wherein, in determining the first distance, the relevant mask edge comprises the nearest mask edge to a respective specular component of the at least one specular component in one or more measurement directions.

22. A metrology method as defined in any preceding clause, wherein said obtaining said metrology data comprises:

illuminating the periodic structure with said partial coherent illumination;
capturing scattered radiation from said periodic structure as a result of said illuminating at a detection plane, said scattered radiation comprising illumination passing through the at least one angularly resolved plane between said periodic structure and detection plane, said angularly resolved plane comprising the at least one mask edge.

23. A computer program comprising program instructions operable to perform the method of any of clauses 1 to 21, when run on a suitable apparatus.

24. A non-transitory computer program carrier comprising the computer program of clause 23.

25. A processing device comprising:

a processor; and
the non-transitory computer program carrier of clause 24.

26. A metrology apparatus being operable to perform the method of any of clauses 1 to 22.

27. A metrology apparatus as defined in clause 26, comprising:

a substrate holder for holding a substrate;
projection optics for projecting illumination onto a substrate;
a detector for detecting said scattered radiation at a detection plane; and
a mask comprising at least one mask edge in an angularly resolved plane between the substrate holder and detector.

28. A metrology apparatus as defined in clause 27, further comprising a partial coherent illumination source for generating said illumination.

29. A metrology apparatus as defined in clause 27 or 28, comprising a detection pupil stop defining an extent of a detection numerical aperture, wherein said at least one mask edge comprises an edge of the detection pupil stop.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of an inspection or metrology apparatus, embodiments of the invention may be used in other apparatus. Embodiments of the invention may form part of a mask inspection apparatus, a lithographic apparatus, or any apparatus that measures or processes an object such as a wafer (or other substrate) or mask (or other patterning device). The term "metrology apparatus" may also refer to an inspection apparatus or an inspection system. E.g. the inspection apparatus that comprises an embodiment of the invention may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference may have been made above to the use of embodiments of the invention in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch P of the metrology targets may be close to the resolution limit of the optical system of the scatterometer or may be smaller, but may be much larger than the dimension of typical product features made by lithographic process in the target portions C. In practice the lines and/or spaces of the overlay gratings within the target structures may be made to include smaller structures similar in dimension to the product features.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1.  A metrology method comprising:

obtaining metrology data relating to a measurement obtained by illuminating a periodic structure comprising at least one pitch with partial coherent illumination comprising a wavelength and
capturing the resultant scattered radiation from said periodic structure at a detection plane, said scattered radiation passing through at least one angularly resolved plane between said periodic structure and detection plane, said angularly resolved plane comprising at least one mask edge;

non-iteratively reconstructing a field of said scattered radiation;
using said reconstructed field to determine a parameter of interest of the structure; and in an initial step:
selecting said wavelength and a maximum of said at least one pitch such that the wavelength-over-pitch ratio is greater than a first distance in said angularly resolved plane, said first distance comprising the distance between said at least one mask edge and a furthest extent of at least one specular component of the scattered radiation with respect to said mask edge.

2. A metrology method as claimed in claim 1, wherein the reconstructed field represents an average of individual fields from individual point sources within the partial coherent illumination.

3. A metrology method as claimed in claim 1 or 2, wherein said selecting said wavelength and pitch further comprises: selecting an illumination configuration and therefore said first distance in addition to said wavelength and pitch such that the wavelength-over-pitch ratio is greater than the first distance in said angularly resolved plane.

4. A metrology method as claimed in any preceding claim, comprising defining a region of interest within said angularly resolved plane, said region of interest comprising at least a portion of each diffraction order of a plurality of diffraction orders of interest comprised within said captured scattered radiation, said plurality of diffraction orders of interest comprising at least one complementary pair of diffraction orders.

5. A metrology method as claimed in claim 4, comprising:

reimaging a local reconstructed field, the local reconstructed field comprising said reconstructed field cropped to correspond only to the region of interest; and
determining said parameter of interest from the reimaged local reconstructed field.

6. A metrology method as claimed in claim 5, wherein said reimaging step comprises digitally reimaging the local reconstructed field.

7. A metrology method as claimed in claim 5 or 6, comprising performing digital processing on the local reconstructed field.

8. A metrology method as claimed in claim 7, wherein said digital processing comprises digital correction and/or filtering to correct for, reduce and/or remove optical aberration and/or correct for, reduce and/or remove the impact of optical crosstalk.

9. A metrology method as claimed in any of claims 5 to 8, comprising determining said parameter of interest from a comparison of reimaged diffraction orders of each of the at least one complementary pair of diffraction orders, as reimaged from said local reconstructed field.

10. A metrology method as claimed in claim 9, wherein said region of interest comprises a corresponding proportion of each of the diffraction orders of each of the at least one complementary pair of diffraction orders.

11. A metrology method as claimed in any of claims 4 to 10, comprising, in said step of non-iteratively reconstructing a field, using a Kramers-Kronig based algorithm to retrieve a phase of at least the diffraction orders of interest.

12. A metrology method as claimed in claim 11, wherein said phase of at least the diffraction orders of interest is retrieved with respect to a phase of the specular component.

13. A metrology method as claimed in any preceding claim, wherein said at least one mask edge comprises at least one edge of a detection pupil stop and/or extent of a detection numerical aperture.

14. A metrology method as claimed in any preceding claim, wherein said illumination comprises two beams, illumination said structure from two directions

15. A metrology apparatus being operable to perform the method of any of claims 1 to 14 further comprising:

a substrate holder for holding a substrate;
projection optics for projecting illumination onto a substrate;

a detector for detecting said scattered radiation at a detection plane; and
a mask comprising at least one mask edge in an angularly resolved plane between the substrate holder and detector.

Fig. 1

Fig. 2

Fig. 3

Fig. 4

Fig. 5

Fig. 6

Fig. 7

Fig. 8

Fig. 9

Fig. 10

(c)

Fig. 11

Fig. 12

Europäisches
Patentamt

European
Patent Office

Office européen
des brevets

**EUROPEAN SEARCH REPORT**

Application Number

EP 24 15 7507

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | "METROLOGY METHOD AND ASSOCIATED METROLOGY DEVICE", RESEARCH DISCLOSURE, KENNETH MASON PUBLICATIONS, HAMPSHIRE, UK, GB , vol. 702, no. 57 1 September 2022 (2022-09-01), XP007150632, ISSN: 0374-4353 Retrieved from the Internet: URL:https://www.researchdisclosure.com/database/RD702057 [retrieved on 2022-09-15] | 15 | INV. G03F7/00 |
| A | * paragraphs [0028], [0046], [0047], [0058], [0059], [0073] - [0081]; figures 4,7 * | 1-14 | |
| | ----- | | |
| X | WO 2020/254041 A1 (ASML NETHERLANDS BV [NL]) 24 December 2020 (2020-12-24) | 15 | |
| A | * paragraphs [0038] - [0041], [0047] - [0053], [0086] - [0089] * | 1-14 | |
| | ----- | | TECHNICAL FIELDS SEARCHED (IPC) |
| X | WO 2022/263231 A1 (ASML NETHERLANDS BV [NL]) 22 December 2022 (2022-12-22) | 15 | G03F |
| A | * paragraphs [0045] - [0060], [0069] * | 1-14 | |
| | ----- | | |

The present search report has been drawn up for all claims

| Place of search | Date of completion of the search | Examiner |
|---|---|---|
| Munich | 5 August 2024 | Roesch, Guillaume |

EPO FORM 1503 03.82 (P04C01)

## ANNEX TO THE EUROPEAN SEARCH REPORT
## ON EUROPEAN PATENT APPLICATION NO.

EP 24 15 7507

This annex lists the patent family members relating to the patent documents cited in the above-mentioned European search report.
The members are as contained in the European Patent Office EDP file on
The European Patent Office is in no way liable for these particulars which are merely given for the purpose of information.

05-08-2024

| Patent document cited in search report | | Publication date | Patent family member(s) | | Publication date |
|---|---|---|---|---|---|
| WO 2020254041 | A1 | 24-12-2020 | CN | 114008531 A | 01-02-2022 |
| | | | IL | 288280 A | 01-01-2022 |
| | | | KR | 20220010548 A | 25-01-2022 |
| | | | TW | 202119132 A | 16-05-2021 |
| | | | US | 2022299888 A1 | 22-09-2022 |
| | | | WO | 2020254041 A1 | 24-12-2020 |
| WO 2022263231 | A1 | 22-12-2022 | IL | 308972 A | 01-01-2024 |
| | | | JP | 2024525300 A | 12-07-2024 |
| | | | KR | 20240023593 A | 22-02-2024 |
| | | | WO | 2022263231 A1 | 22-12-2022 |

EPO FORM P0459

For more details about this annex : see Official Journal of the European Patent Office, No. 12/82

**REFERENCES CITED IN THE DESCRIPTION**

**Patent documents cited in the description**

- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1
- US 20190107781 A
- WO 2021121733 A1
- WO 2021121733 A
- WO 2020254041 A

**Non-patent literature cited in the description**

- **NAKAJIMA, N.** ; **T. ASAKURA.** Two-dimensional phase retrieval using the logarithmic Hilbert transform and the estimation technique of zero information. *Journal of Physics D: Applied Physics*, 1986, vol. 19 (3), 319
- **BAEK, Y.** ; **LEE, K.** ; **SHIN, S** ; **PARK, Y**. Kramers-Kronig holographic imaging for high-space-bandwidth product.. *Optica, OPTICA*, 2019, vol. 6, 45-51
- **BAEK, Y** ; **PARK, Y.** Intensity-based holographic imaging via space-domain Kramers-Kronig relations. *Nat. Photonics*, 2021, vol. 15, 354-360
- **SHEN, C.** ; **LIANG, M** ; **PAN, A** ; **YANG, C**. Non-iterative complex wave-field reconstruction based on Kramers-Kronig relations. *Photon. Res., PRJ*, 2021, vol. 9, 1003-1012